# EUROPEAN PATENT SPECIFICATION

(11) **EP 3 282 817 B1**
(45) Date of publication and mention of the grant of the patent: **01.07.2020**
(21) Application number: 17151382.3
(22) Date of filing: 13.01.2017
(51) Int. Cl.: H05B 6/64

(54) **STRUCTURE FOR COVERING CONNECTION LINE, ELECTRIC COOKING APPLIANCE INCLUDING THE SAME, AND METHOD OF ASSEMBLING CAP OF ELECTRIC COOKING APPLIANCE**
ELEKTRISCHE KOCHVORRICHTUNG UND VERFAHREN ZUM MONTIEREN EINER KAPPE DER ELEKTRISCHEN KOCHVORRICHTUNG
APPAREIL DE CUISSON ÉLECTRIQUE ET PROCÉDÉ D'ASSEMBLAGE D'UN CACHE DE L' APPAREIL DE CUISSON ÉLECTRIQUE

(30) Priority: 10.08.2016 KR 20160101706
(43) Date of publication of application: 14.02.2018
(73) Proprietor: LG ELECTRONICS INC., Yeongdeungpo-gu Seoul, 07336 (KR)
(72) Inventor: YEO, Taehong, 08592 Seoul (KR)
(74) Representative: Vossius & Partner Patentanwälte Rechtsanwälte mbB

(56) References cited:
- EP-A2- 2 333 426
- CN-A- 1 467 421
- DE-A1- 4 304 525
- JP-A- S6 112 578
- KR-A- 20050 005 018

## Description

The present disclosure relates to an electric cooking appliance including a structure for covering a connection line and to a method of assembling a cap of the electric cooking appliance.

Thus far, various types of apparatuses have been proposed to heat food. A primitive heating apparatus may be a container directly in contact with a heat source, in which content to be cooked is placed and heated.

Many types of cooking apparatuses that directly or indirectly use electric energy have been developed, and an example of a cooking apparatus may include a microwave oven using microwave as a heater. A microwave oven may generate microwaves using electricity and infiltrate the microwaves into a cooking object accommodated in a cooking chamber to heat by causing a molecular motion in the cooking object.

The microwave oven may irradiate a high frequency of magnetron to a cooking object and simultaneously heat internal and external parts of the cooking object. The microwave oven has been widely used due to advantages that a cooking time of food is remarkably reduced due to high thermal efficiency, loss in a nutritional value may be reduced during cooking, thawing, and heating procedures of food, and food is capable of being cooked while being contained in a container.

In general, such a microwave oven may include a door to open and close a cooking chamber formed in a main body. Examples of the door included in the microwave oven may include a right and left opening door, an up and down opening door, a sliding door, and so on according to an opening type. The most commonly used method is the right and left opening door.

A control panel may be provided on a front surface of a microwave oven. In general, the control panel may be installed in a main body so as to be positioned at a lateral portion of a door and include a plurality of functional keys related to control an operation of the microwave oven by a user.

Recently, microwave ovens have been formed by installing a separate functional portion using an extra space of a machine room corresponding to a portion of a control panel and a rear portion thereof and installing the control panel in a door. When a control panel is installed in a main body, a connection line between the main body and the control panel may be positioned in the main body so as not to be externally exposed.

However, when a control panel is installed in a door, a connection line connected to a main body needs to extend from the main body to be connected to the control panel and, thus, the connection line is inevitably and externally exposed at a connection portion between the main body and the door. In this regard, when the connection line is externally exposed, this provides an aesthetically unappealing sight and the connection line is in danger of being damaged.

As a method of overcoming this problem, a connection line may be prevented from being exposed by installing a separate cap on a portion through which a connection line is exposed and accommodating the connection line in the installed cap. In general, a predetermined space for accommodating a connection line exposed outside a main body may be provided in a cap and the cap may be installed by arranging the cap on a bottom surface of the main body and then coupling the cap to the bottom surface of the main body via a fastener such as a bolt.

However, when such a structure for installing the cap is used, the main body of the microwave oven may need to be reversibly positioned such that the bottom surface on which the cap is to be installed is directed upward during an operation of coupling the cap to the main body. Thus, there the operation may be difficult and working time may be increased.
JP S61 12578 A discloses a power cord housing device for a heating cooker.
DE 43 04 525 A1 discloses an arrangement of a connecting socket for the connection of electrical supply cables.
EP 2 333 426 A2 discloses a household appliance comprising a cable, a cable guide, an edge protector and a surface with a recess which is provided for surrounding an area of the surface.

The embodiments will be described in detail with reference to the following drawings in which like reference numerals refer to like elements wherein:
FIG. 1 is a schematic perspective view of an electric cooking appliance according to an exemplary embodiment of the present disclosure.
FIG. 2 is an exploded perspective view of a structure of an electric cooking appliance according to an exemplary embodiment of the present disclosure.
FIG. 3 is an enlarged bottom view of a portion of an electric cooking appliance according to an exemplary embodiment of the present disclosure.
FIG. 4 is an exploded perspective view of a base plate and a cap according to an exemplary embodiment of the present disclosure.
FIG. 5 is a perspective view illustrating a coupling state of a base plate and a cap according to an exemplary embodiment of the present disclosure.
FIG. 6 is a cross-sectional view taken along a line **"VI-VI"** of FIG. 5.
FIG. 7 is a perspective view of a completely assembled state of a cap according to an exemplary embodiment of the present disclosure.
FIG. 8 is a cross-sectional view taken along a line **"VIII-VIII"** of FIG. 7.
FIG. 9 is a flowchart illustrating a method of manufacturing an electric cooking appliance according to an exemplary embodiment of the present disclosure.
FIG. 10 is a cross-sectional view illustrating a state in which a cap of an electric cooking appliance is completely assembled according to another embodiment of the present disclosure which is not part of the claimed invention.

Hereinafter, a structure for covering a connection line, an electric cooking appliance including the same, and a method of assembling a cap of the electric appliance will be described with regard to exemplary embodiments of the invention with reference to the attached drawings. For convenience of description, the thicknesses of lines and the size of components in the drawings are exaggerated for clarity. The terms used in the specification are defined in consideration of functions used in the present disclosure, and can be changed according to intent or conventionally used methods of clients, operators, and users. Accordingly, definitions of the terms should be understood on the basis of the entire description of the present specification.

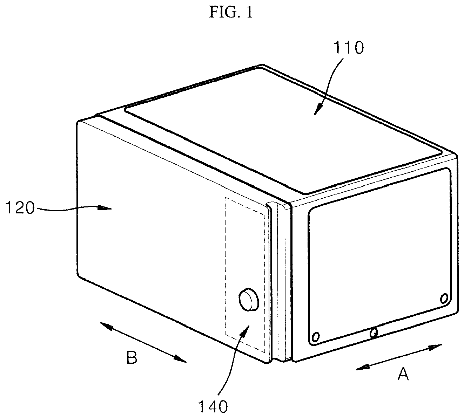

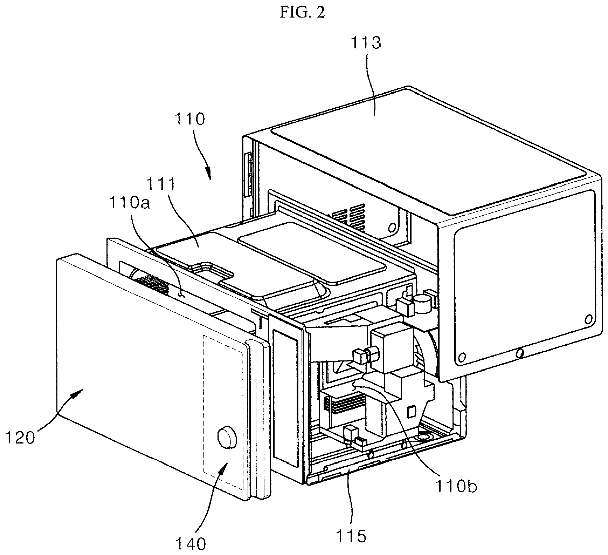

Referring to Figures 1 and 2, the electric cooking appliance according to an exemplary embodiment includes a main body 110 and a door 120. According to the present exemplary embodiment, a microwave oven irradiating a high frequency of a magnetron to a cooking object and simultaneously heating internal and external parts of the cooking object will be described as an example of an electric cooking appliance. However, the present disclosure is not limited thereto and various types of electric cooking appliances, such as an electric cooking appliance including an electric heater instead of a magnetron and an electric cooking appliance including both a magnetron and an electric heater may be included in the scope of the present disclosure.

The main body 110 forms the outer appearance of the electric cooking appliance and may be shaped like an approximate rectangular parallelepiped. The main body 110 includes a cavity 111, a case 113, and a base plate 115.

The cavity 111 forms a frame of the main body 110. The cavity 111 includes a cooking chamber 110a formed therein to accommodate an object to be cooked so as to be opened forward and a machine room 110b formed at a lateral side of the cooking chamber 110a. Electric components such as a magnetron and a high voltage transformer may be installed in the machine room 110b.

The case 113 covers may an external portion of the cavity 111, and covers an upper portion and both lateral portions of the cavity 111 to form the outer appearance of the main body 110. The base plate 115 is arranged on a lower surface of the cavity 111 to constitute the bottom surface of the main body 110.

The cooking chamber 110a may be formed with a front surface being opened in the main body 110 and provides a space to accommodate food therein. The cooking chamber 110a may have a first lateral surface including an inlet through which outside air is introduced and a second lateral surface including an outlet through which the introduced air is externally discharged.

The door 120 is provided at the opened front surface of the cooking chamber 110a. The door 120 may be installed at a front portion of the main body 110, or a front portion of the cooking chamber 110a. One side of the door 120 is rotatably hinged on the main body 110.

A control panel 140 to set various cooking conditions and operate or suspending the electric cooking appliance may be provided at the front portion of the main body 110, in more detail, the front portion of the machine room 110b. The control panel 140 may include a button portion to be manipulated by a user and a display to display information on driving of the electric cooking appliance.

According to the present embodiment, the control panel 140 may be included in the door 120. The control panel 140 may be integrally installed with the door 120 so as to be rotated together with the door 120 when opening and closing the cooking chamber 110a rather than being installed in the main body 110.

The control panel 140 includes a manipulation panel and a substrate. The manipulation panel is exposed through the front surface of the door 120 and may include a button and a display. The substrate is installed in the door 120 so as not to be exposed through the front surface of the door 120 and may include various components to operate the button and display the manipulation panel.

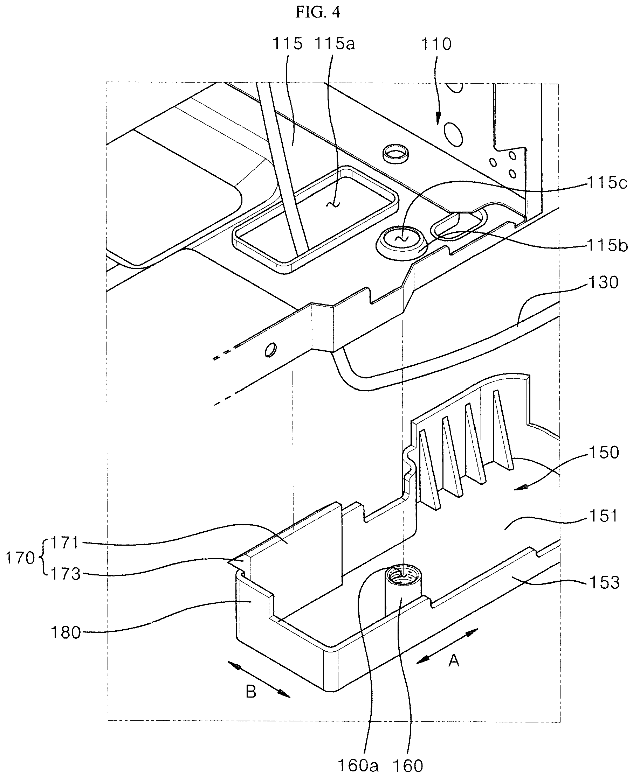

The electric cooking appliance according to the present embodiment includes a connection line or cable 130 (refer to FIG. 4) between the aforementioned control panel 140 and the main body 110. A first side of the connection line 130 is connected to the substrate of the control panel 140 in the door 120. In addition, a second side of the connection line 130 is inserted into the main body 110 through the base plate 115 constituting the bottom surface of the main body 110 so as to be connected to a component such as a machine room substrate installed in the machine room 110b.

A through hole 115a is formed in a vertical direction through the base plate 115 that is arranged below the cavity 111 to constitute the bottom surface of the main body 110. The connection line 130 extends of the main body 110 through the through hole 115a so as to connect components in the main body 110 and the substrate in the door 120.

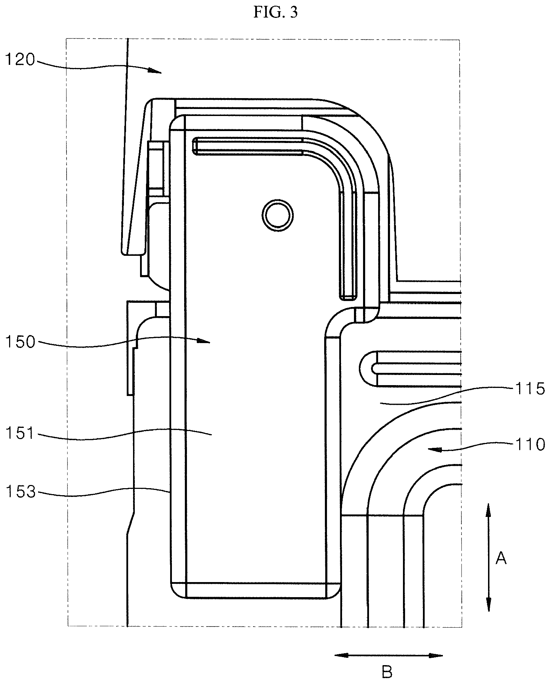

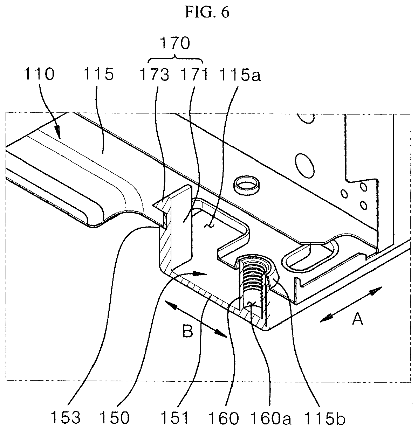

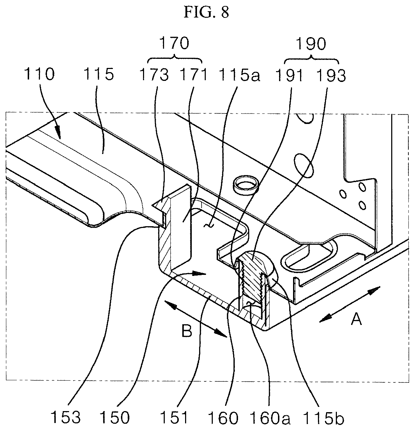

Referring to Figures 3 to 8, the electric cooking appliance further includes a structure covering a connection line, including a cap 150, a coupling boss 160, and a fastener 190. The cap 150 is provided below the base plate 115 and provided with an accommodation space formed therein to accommodate the connection line 130 passing through the through hole 115a above the base plate 115.

The cap 150 functions as a path for installing the connection line 130 and may also support the electric cooking appliance. A first portion of the connection line 130 extending from a lower portion of the base plate 115 through the through hole 115a may inevitably be exposed in a region between the main body 110 and the door 120 below the base plate 115.

The cap 150 may be installed at the region between the main body 110 and the door 120 below the base plate 115, where the first portion of the connection line 130 extends from the lower portion of the base plate 115. The cap 150 accomodates the first portion of the connection line 130 extending from the lower portion of the base plate 115 in the region between the main body 110 and the door 120 below the base plate 115 to prevent the connection line 130 from being externally exposed.

For example, the cap 150 may be shaped like a box with an open upper portion. Accordingly, the cap 150 may include a bottom surface 151 that forms a flat surface spaced apart from the base plate 115 by a predetermined interval, and four lateral walls 153 extending in a vertical direction from the bottom surface 151.

The bottom surface 151 may be formed with a length in a forward and backward direction A, which extends to a portion of the door 120 where the connection line 130 is inserted or drawn out from a portion of the base plate 115, through which the through hole 115a is formed. According to the present embodiment, a direction in which front and rear surfaces of the electric cooking appliance are connected is defined as the forward and backward direction A and a direction in which left and right lateral surfaces of the electric cooking appliance are connected is defined as a right and left direction B.

The lateral wall 153 may extend upward along an edge of the bottom surface 151 and may have an appropriate height so as to form an accommodation space with a sufficient height to accommodate the connection line 130 in the cap 150. The lateral wall 153 may have a height as long as the cap 150 functions as a support of the electric cooking appliance.

The aforementioned cap 150 may be installed in such a way that a first side in the forward and backward direction A surrounds a lower region of the base plate 115 and a second side in the forward and backward direction A surrounds a lower region of the door 120. Thus, the connection line 130 may not be externally exposed in a region between the main body 110 and the door 120.

At least one of the four lateral walls 153 may be formed at a portion at which an upper end portion of the lateral wall 153 interferes with a lower surface of the base plate 115. An upper end portion of the lateral wall 153 provided below the base plate 115 among the lateral walls 153 may be formed at the portion that interferes with the lower surface of the base plate 115.

A position restriction structure restricting a movement in an upward direction of the cap 150 is formed via interference between the lower surface of the base plate 115 and the lateral wall 153 so as to guide a position of the cap 150 in a vertical direction. A coupling boss 160 is formed in the aforementioned cap 150. The coupling boss 160 may be shaped like a cylinder with a length extending in an upward direction from the bottom surface 151 of the cap 150 and, for example, may be integrally molded and formed with the cap 150.

The coupling boss 160 is coupled to the base plate 115 and allows the cap 150 to be coupled to the base plate 115 at a lower portion of the base plate 115. Coupling between the base plate 115 and the coupling boss 160 is achieved by a fastener 190 to be described below.

A first coupling hole 115c may be formed through the base plate 115 in a vertical direction. A second coupling hole 160a may be formed in the coupling boss 160 so as to extend with a hollow shape in a vertical direction and may be open toward an upper portion of the coupling boss 160. As such, a screw thread accepting the fastener 190 to be described later may be formed in the coupling boss 160 in which the second coupling hole 160a is formed.

Accordingly, a coupling structure is formed to couple the base plate 115 and the coupling boss 160 below the base plate 115 using the fastener 190. The first coupling hole 115c and the second coupling hole 160a may have a circular shape with a similar diameter and the cap 150 may be installed at a portion in which the first coupling hole 115c and the second coupling hole 160a overlap each other in a vertical direction.

In addition, a fit wall 115b formed by bending a surrounding portion of the first coupling hole 115c of the base plate 115 in an upward direction may be provided at the surrounding portion of the first coupling hole 115c. The fit wall 115b may taper upward such that a width of the first coupling hole 115c is reduced.

The coupling boss 160 may be fit-coupled to the fit wall 115b through the first coupling hole 115c. According to the fitting between the coupling boss 160 and the fit wall 115b, the cap 150 may be guided to be installed at a position in which the first coupling hole 115c and the second coupling hole 160a overlap each other in a vertical direction. By virtue of an inclination surface formed by the fit wall 115b that tapers upward such that the width of the first coupling hole 115c is reduced, a position for fitting the coupling boss 160 may be stably guided and fit-coupling between the coupling boss 160 and the fit wall 115b may be easily achieved.

The fastener 190 may be inserted through the base plate 115 from an upper portion of the base plate 115 so as to couple the base plate 115 and the coupling boss 160 to each other. The fastener 190 may be a screw configured in such a way that a screw body 191 is inserted into the first coupling hole 115c and the second coupling hole 160a from the upper portion of the base plate 115 and screwed to the coupling boss 160 and a screw head 193 is supported by the upper portion of the base plate 115.

The screw body 191 may be shaped like a cylinder including an outer circumferential surface with a screw thread formed thereon and formed through the base plate 115 via the first coupling hole 115c from the upper portion of the base plate 115. The screw head 193 may protrude from an upper end portion of the screw body 191 and may be supported by the upper portion of the base plate 115 so as to maintain a coupling state between the base plate 115 and the coupling boss 160 together with the screw body 191.

A structure for covering a connection line of an electric cooking appliance according to the present embodiment may further include a hook 170 and a guide rib 180. The hook 170 may be formed at the cap 150 and may protrude upward from the lateral wall 153. The hook 170 may include an elastic extension 171 and a hook protrusion 173.

The elastic extension 171 may be shaped like a plate extending upward from the lateral wall 153 and may be capable of elastically deforming in the right and left direction B. The elastic extension 171 may be positioned inside compared with the lateral wall 153 in the right and left direction B and may extend through the base plate 115 via the through hole 115a.

The elastic extension 171 may interfere with an inner circumferential surface of the through hole 115a when being inserted through the base plate 115 via the through hole 115a. According to interference between the elastic extension 171 and the inner circumferential surface of the through hole 115a, a position of one side of the cap 150 coupled to the base plate 115 may be guided in the right and left direction B

The hook protrusion 173 may protrude from an upper end portion of the elastic extension 171. The hook protrusion 173 may interfere with an upper surface of the base plate 115 when positioned on the upper portion of the base plate 115. According to interference between the upper surface of the base plate 115 and the hook protrusion 173, a downward movement of the cap 150 coupled to the base plate 115 may be restricted.

The hook 170 including the elastic extension 171 and the hook protrusion 173 may interfere with the inner circumferential surface of the through hole 115a so as to guide a position of one side of the cap 150 coupled to the base plate 115 in the right and left direction B and interfere with the upper surface of the base plate 115 so as to restrict a downward movement of the cap 150 coupled to the base plate 115. The hook 170 may guide a position of the cap 150 coupled to the base plate 115 before the cap 150 is coupled to the fastener 190 and may primarily fix the cap 150 at the guided installation position.

The guide rib 180 may be formed on the cap 150 so as to protrude upward from the upper portion of the lateral wall 153. The guide rib 180 may extend through the base plate 115 via the through hole 115a and may contact the inner circumferential surface of the through hole 115a while extending through the base plate 115 via the through hole 115a.

According to the present embodiment, the hook 170 may include a wall surface with a width extending in the forward and backward direction A and the guide rib 180 may include a wall surface with a width extending in the right and left direction B. The hook 170 and the inner circumferential surface of the through hole 115a may contact each other in the right and left direction B, whereas the guide rib 180 and the inner circumferential surface of the through hole 115a may contact each other in the forward and backward direction A.

According to the contact between the guide rib 180 and the inner circumferential surface of the through hole 115a, a position of one side of the cap 150 coupled to the base plate 115 may be guided in the forward and backward direction A.

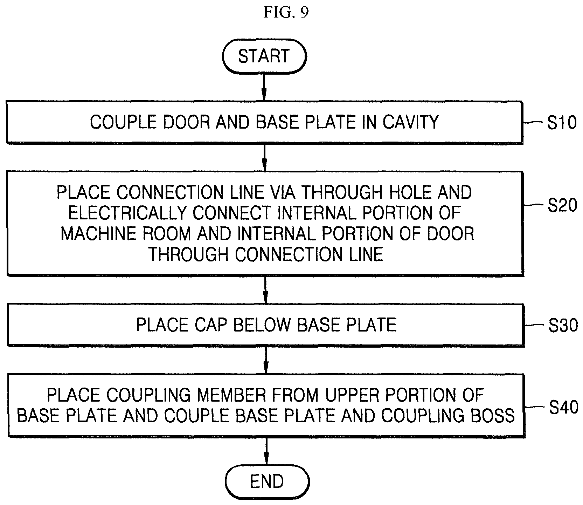

Hereinafter, with reference to Figures 3 to 9, a method of assembling a cap of an electric cooking appliance and an operation and effect of an electric cooking appliance assembled with a cap using the method according to an exemplary embodiment of the present disclosure will be described. As illustrated in Figures 2 and 3, in order to assemble the cap 150 installed below the electric cooking appliance with a lower portion of the base plate 115, as illustrated in Figures 2 and 9, the door 120 is rotatably coupled in front of the cavity 111 and the base plate 115 is coupled to a lower portion of the cavity 111 (S10).

The control panel 140 may be located in the door 120 coupled in front of the main body 110. The control panel 140 may include a manipulation panel that is exposed through a front surface and a substrate that is installed in the door 120 so as not to be exposed through the front surface of the door 120.

The through hole 115a is formed through the base plate 115 coupled to the lower portion of the cavity 111 in a vertical direction. The base plate 115 is installed below the cavity 111 such that the through hole 115a is positioned adjacent to a front portion, or a portion in which the main body 110 and the door 120 are rotatably coupled to each other.

As illustrated in Figures 4 and 9, the connection line 130 is placed through the through hole 115a and an internal portion of the machine room 110b and an internal portion of the door 120 may be electrically connected to each other through the connection line 130 (S20). Accordingly, the connection line 130 may be installed in such a way that a first side is connected to a substrate of the control panel 140 in the door 120 (refer to FIG. 3) and a second side is inserted into the main body 110 through the base plate 115 to be connected to a component such as a machine room substrate installed in the machine room 110b.

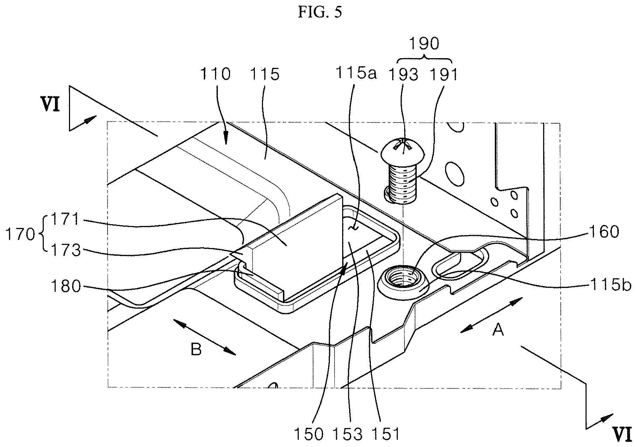

In a region between the main body 110 and the door 120, which is deviated from the internal portion of the main body 110 and the internal portion of the door 120, a portion of the connection line 130 may be exposed out of the electric cooking appliance. As described above, when the connection line 130 is completely installed, the cap 150 may be positioned below the base plate 115 to fix the base plate 115 and the cap 150 so as to accommodate the externally exposed portion of the connection line 130 (refer to FIG. 4), or the portion of the connection line 130 exposed out of the electric cooking appliance, as illustrated in Figures 5, 6, and 9 (S30).

This procedure may be performed by inserting the hook 170 into the through hole 115a so as to allow the hook 170 provided in the cap 150 to latch with the inner circumferential surface of the through hole 115a and fit-couple the coupling boss 160 to the fit wall 115b provided in the base plate 115. Accordingly, the hook 170 and the inner circumferential surface of the through hole 115a may contact each other at a first side of the cap 150 in the right and left direction B and the coupling boss 160 and the fit wall 115b may be fit-coupled to each other at a second side of the cap 150 in the right and left direction B.

As such, according to interference between the hook 170 and the inner circumferential surface of the through hole 115a and the fit-coupling between the coupling boss 160 and the fit wall 115b at a first side and the second side of the cap 150 in the right and left direction B, a position of the cap 150 coupled to the base plate 115 may be guided in the right and left direction B. When the hook 170 is inserted into the through hole 115a, the guide rib 180 positioned adjacent to the hook 170 may also be inserted into the through hole 115a and, accordingly, the guide rib 180 and the inner circumferential surface of the through hole 115a may contact each other.

According to contact between the guide rib 180 and the inner circumferential surface of the through hole 115a and the fit-coupling between the coupling boss 160 and the fit wall 115b, a position of the cap 150 coupled to the base plate 115 may be guided in the forward and backward direction A. According to guidance of the positions of the cap 150 in the right and left direction B and the forward and backward direction A, the installation position of the cap 150 may be guided to a position in which the first coupling hole 115c (refer to FIG. 4) of the base plate 115 and the second coupling hole 160a (refer to FIG. 4) of the coupling boss 160 overlap each other in a vertical direction and the cap 150 may be primarily fixed at the guided installation position.

Accordingly, the position of the cap 150 is primarily fixed at a position to couple the base plate 115 and the coupling boss 160 via the fastener 190 above the base plate 115 and subsequent coupling of the fastener 190 may be easily and stably performed. The hook 170 inserted into the through hole 115a as described above may contact the upper surface of the base plate 115 via the hook protrusion 173 so as to restrict a downward movement of the cap 150 coupled to the base plate 115.

The lateral wall 153 of the cap 150 and a lower surface of the base plate 115 may contact each other below the portion in which the hook 170 and the upper surface of the base plate 115 contact each other so as to restrict an upward movement of the cap 150. According to contact between the hook 170 and the upper surface of the base plate 115 and contact between the lateral wall 153 of the cap 150 and the lower surface of the base plate 115, the position of the cap 150 coupled to the base plate 115 may be guided and fixed in a vertical direction.

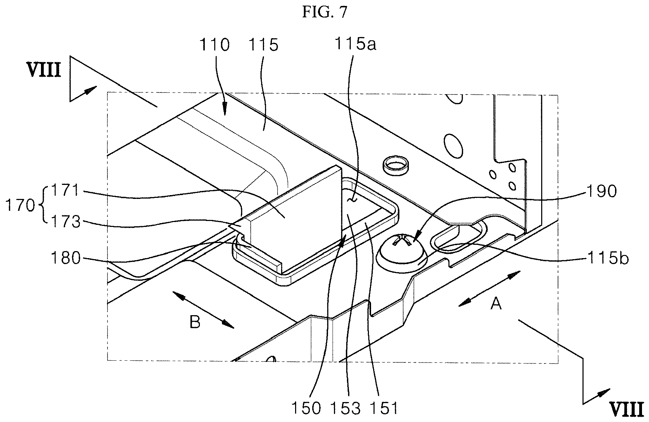

As described above, when the position of the cap 150 is completely guided and fixed, the fastener 190 is placed through the base plate 115 from the upper portion of the base plate ,115 and the base plate 115 and the coupling boss 160 is coupled (S40) so as to completely assemble the cap 150, as illustrated in Figures 7 to 9. Conventionally, a main body of an electric cooking appliance may be reversibly positioned such that a bottom surface of the electric cooking appliance on which a cap is to be installed is directed upward. Then, the cap may be coupled to the main body of the electric cooking appliance by inserting into the main body while passing through the cap and the bottom surface of the main body from the outside of the main body.

Due to a position for installing the cap on the bottom surface of the main body, when the main body of the electric cooking appliance is not reversibly positioned, the installation position of the cap may not be accurately recognized and a space for coupling the screw is not ensured. However, when the main body of the electric cooking appliance is reversibly positioned in order to install the cap, the operation may be difficult and working time increased.

An operation of turning the reversibly positioned main body over to an original state after the cap is completely installed then needs to be further performed. Thus, a workload and working time may be increased, a product may be damaged while the main body is reversibly place, or there may be safety hazards such as operators' injuries.

Compared with the conventional case, according to the present embodiment, even if the main body 110 of the electric cooking appliance is not reversibly positioned, the structure covering a connection line so as to install the cap 150 may be provided. Accordingly, the fastener 190 may be a screw including a screw body 191 and a screw head 193 and the first coupling hole 115c and the second coupling hole 160a may be open upward in the base plate 115 and the coupling boss 160 in which the fastener 190 is inserted and coupled.

Accordingly, the fastener 190 may be inserted into the first coupling hole 115c and the second coupling hole 160a from the upper portion of the base plate 115 and coupled to the base plate 115 and the coupling boss 160. The coupling operation of the cap 150 may be performed when the main body 110 is right side up to direct the lower surface of the base plate 115 downward, but not in a state in which the main body 110 is upside down to direct the lower surface of the base plate 115 upward.

Without a difficult operation of turning over the main body 110, the cap 150 may be installed with a lower degree of difficulty while also reducing working time taken for the operation of installing the cap 150. In the aforementioned coupling structure, the portion of the fastener 190 placed through the main body 110 may be accommodated in the cap 150 in the coupling boss 160 so as not to be exposed out of the main body 110.

Accordingly, the fastener 190 used to install the cap 150 may be prevented from being externally exposed to degrade an overall appearance of the electric cooking appliance or damage a user. When the structure covering a connection line according to the present embodiment is used, the cap 150 may be guided to a targeted position to install the cap 150 simply by fitting the coupling boss 160 provided in the cap 150 to the fit wall 115b and inserting the hook 170 of the cap 150 into the through hole 115a. Thus, the cap 150 may be accurately placed at a targeted position even when the cap 150 is not accurately recognized by being hidden by the base plate 115.

When the position of the cap 150 is guided as described above, the cap 150 may be fixed at the corresponding position via hook coupling between the hook 170 and the base plate 115 and fit-coupling between the coupling boss 160 and the fit wall 115b at the guided position. As such, when the cap 150 is fixed, the operation of installing the cap 150 may be very easily and rapidly performed simply by coupling the fastener 190 to the upper portion of the base plate 115 without performing a subsequent operation of re-adjusting the cap 150 or fixing the cap 150 using a separate device or help of another operator.

When the structure covering a connection line, the electric cooking appliance including the same, and the method of assembling a cap of the electric cooking appliance are used, the cap 150 may be stably installed on the bottom surface of the main body 110 without a difficult operation of turning over the main body 110. Thus, degree of difficulty of the operation of installing the cap 150 may be lowered and working time taken to install the cap 150 may also be reduced.

When the structure covering a connection line, the electric cooking appliance including the same, and the method of assembling a cap of the electric cooking appliance according to the present invention are used, it may not be necessary to turn over the main body 110 in order to install the cap 150 on the bottom surface of the main body 110, thereby preventing a product being damaged or safety hazard such as operators' injuries from occurring while the main body is turned over. The cap 150 may be guided to a targeted position simply by fitting the coupling boss 160 provided in the cap 150 to the fit wall 115b and inserting the hook 170 of the cap 150 into the through hole 115a. The cap 150 may be fixed at the guided position, and thus, may enhance stability and convenience of the operation of installing the cap 150.

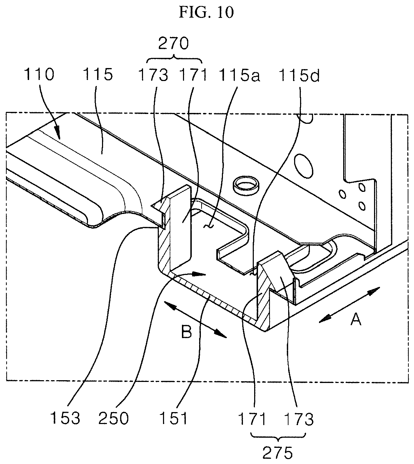

The aforementioned structure covering a connection line, the electric cooking appliance including the same, and the method of assembling a cap of the electric cooking appliance is merely an example of an exemplary embodiment of the present disclosure and there may be various embodiments for substituting the example. Hereinafter, another embodiment of the present disclosure will be described with reference to FIG. 10. The same reference numeral as in the above diagrams denotes the same member for the same function and, thus, a repeated description will be omitted here.

Referring to FIG. 10, an electric cooking appliance according to another embodiment not being part of the claimed invention may include a structure covering a connection line, including a cap 250, a first hook 270, and a second hook 275. The cap 250 may include the bottom surface 151 and the lateral wall 153 like the cap 150 (refer to FIG. 4) according to the aforementioned embodiment.

The first hook 270 may include the elastic extension 171 and the hook protrusion 173 like in the hook 170 (refer to FIG. 4) according to the aforementioned embodiment and may be provided at a first side of the cap 250 in the right and left direction B. The first hook 270 may be inserted through the base plate 115 through the through hole 115a and hook-coupled to the base plate 115 to couple one side of the cap 250 to the base plate 115.

According to hook coupling between the first hook 270 and the base plate 115, a position of one side in the right and left direction B may be guided via contact between the first hook 270 and the inner circumferential surface of the through hole 115a. A position of the cap 250 in an upward direction may be guided and fixed via contact between the first hook 270 and the upper surface of the base plate 115 and contact between the lateral wall 153 of the cap 250 and the lower surface of the base plate 115.

The second hook 275 may include the elastic extension 171 and the hook protrusion 173 like the first hook 270 and may be provided at a second side of the cap 250 in the right and left direction B. The second hook 275 may be inserted through the base plate 115 at a different position from the first hook 270 and hook-coupled to the base plate 115 to couple the other side of the cap 250 to the base plate 115.

A hook hole 115d as a path for placing the second hook 275 through the base plate 115 may be formed through the base plate 115 separately from the through hole 115a. Accordingly, the second hook 275 may be inserted through the base plate 115 via the hook hole 115d and hook-coupled to the base plate 115 so as to couple the second side of the cap 250 to the base plate 115.

According to hook coupling between the second hook 275 and the base plate 115, a position of the second side of the cap 250 in the right and left direction B may be guided via contact between the second hook 275 and the inner circumferential surface of the hook hole 115d. A position of the cap 250 in an upward direction may be guided and fixed via contact between the second hook 275 and the upper surface of the base plate 115 and contact between the lateral wall 153 of the cap 250 and the lower surface of the base plate 115.

The through hole 115a may be formed in such a way that both the first hook 270 and the second hook 275 may be inserted through the base plate 115 via the through hole 115a without separately forming the hook hole 115d in the base plate 115. According to the aforementioned structure including the first hook 270 and the second hook 275, a primary fixing operation and a last coupling operation between the base plate 115 and the cap 250 may be performed at one time.

The coupling operation of the cap 250 may be completed at one time without an additional operation of coupling a screw simply by fit-coupling the first hook 270 and the second hook 275 to the base plate 115. Thus, the operation of installing the cap 250 may be more easily and rapidly performed.

The present disclosure described above may be variously substituted, altered, and modified by those skilled in the art to which the present disclosure pertains without departing from the scope of the present disclosure. Therefore, the present disclosure is not limited to the above-mentioned exemplary embodiments and the accompanying drawings.

## Claims

1. An electric cooking appliance comprising a cavity (111) comprising a cooking chamber (110a) and a machine room (110b); a door (120) rotatably coupled to the cavity (111) and configured to open and close the cooking chamber (110a);
a base plate (115) provided below the cavity (111) and including a through hole (115a) formed therethrough in a vertical direction;
a connection line (130) extending out of the cavity (111) through the through hole (115a), said connection line (130) also extending from the machine room (110b) and being connected to an internal portion of the door (120); a cap (150) provided below the base plate (115) and having an accommodation space formed therein to accommodate a portion of the connection line (130), which extends out of the cavity (111);
a coupling boss (160) extending in a vertical direction at the cap (150) and coupled to the base plate (115) below the base plate (115); and
a fastener (190) inserted through the base plate (115) from the upper portion of the base plate (115) to couple the base plate (115) and the coupling boss (160).

2. The electric cooking appliance according to claim 1, further including a control panel (140) provided in the door (120),
wherein the connection line (130) is connected to the control panel (140) in the door (120).

3. The electric cooking appliance according to claim 2,
wherein the control panel (140) includes a manipulation panel that is exposed through a front surface and a substrate that is installed in the door (120) so as not to be exposed through the front surface of the door (120),
wherein the connection line (130) is connected to the substrate in the door (120).

4. The electric cooking appliance according to claims 2 or 3, wherein:
a first coupling hole (115c) is formed in the base plate (115) in a vertical direction;
a second coupling hole (160c) is open upward in the coupling boss (160); and
the cap (150) is installed at a portion in which the first coupling hole (115c) and the second coupling hole (160c) overlap each other in a vertical direction.

5. The electric cooking appliance according to any one of claims 1 to 4, wherein:
the base plate (115) includes a fit wall (115b) formed by bending a surrounding portion of the first coupling hole (115c) in an upward direction; and
the coupling boss (160) is fit-coupled to the fit wall (115b) through the first coupling hole (115c).

6. The electric cooking appliance according to claim 5, wherein the fit wall (115b) tapers upward such that a diameter of the first coupling hole (115c) is reduced.

7. The electric cooking appliance according to claim 5 or 6, further including a hook (170) provided at the cap (150), inserted through the base plate (115) via the through hole (115a), and contacting an inner circumferential surface of the through hole (115a),
wherein a position of the cap (150) coupled to the base plate (115) is guided in a right and left direction via contact between the hook (170) and an inner circumferential surface of the through hole (115a) at a first side of the cap (150) and fit-coupling between the coupling boss (160) and the fit wall (115b) at the a second side of the cap (150).

8. The electric cooking appliance according to any one of claims 5 to 7, further including a guide rib (180) provided at the cap (150), inserted through the base plate (115) via the through hole (115a), contacting with an inner circumferential surface of the through hole (115a),
wherein a position of the cap (150) coupled to the base plate (115) is guided in a forward and backward direction via fit-coupling between the coupling boss (160) and the fit wall (115b) and contact between the guide rib (180) and an inner circumferential surface of the through hole (115a).

9. The electric cooking appliance according to any one of claims 4 to 8, wherein the fastener (190) is a screw configured in such a way that a screw body (191) is inserted into the first coupling hole (115c) and the second coupling hole (160a) from the upper portion of the base plate (115) and screwed to the coupling boss (160) and a screw head (193) is supported by the upper portion of the base plate (115).

10. The electric cooking appliance according to any one of claims 1 to 9, wherein:
the cap (150) includes a bottom surface (151) spaced apart from the base plate (115) by a predetermined distance and a lateral wall (153) extending from the bottom surface (151) in a vertical direction; and
an upper end portion of at least a portion of the lateral wall (153) contacts a lower surface of the base plate (115) to restrict upward movement of the cap (150).

11. A method of assembling a cap (150) of the electric cooking appliance according to claim 1, the method comprising:
rotatably coupling the door (120) in front of the cavity (111) and coupling the base plate (115) below the cavity (111);
placing a connection line (130) through the through hole (115a) and electrically connecting an internal portion of the machine room (110b) and an internal portion of the door (120) through the connection line (130);
placing the cap (150) below the base plate (115) so as to accommodate a portion of the connection line (130), which extends out of the cavity (111); and
placing a fastener (190) through the base plate (115) from an upper portion of the base plate (115) and coupling the base plate (115) and the coupling boss (160).

12. The method according to claim 11, wherein the placing of the cap (150) below the base plate (115) comprises inserting a hook (170) provided at the cap (150) into the through hole (115a) such that the hook (170) interferes with an inner circumferential surface of the through hole (115a) and fit-coupling the coupling boss (160) to a fit wall (115b) provided at the base plate (115).

## Patentansprüche

1. Elektrische Kochvorrichtung, die aufweist:
einen Hohlraum (111) mit einer Kochkammer (110a) und einem Maschinenraum (110b);
eine Tür (120), die drehbar mit dem Hohlraum (111) gekoppelt und konfiguriert ist, die Kochkammer (110a) zu öffnen und zu schließen;
eine Grundplatte (115), die unter dem Hohlraum (111) vorgesehen ist und ein Durchgangsloch (115a) aufweist, das dort hindurch in einer vertikalen Richtung ausgebildet ist;
eine Verbindungsleitung (130), die sich durch das Durchgangsloch (115a) aus dem Hohlraum (111) heraus erstreckt, wobei sich die Verbindungsleitung (130) auch vom Maschinenraum (110b) erstreckt und mit einem inneren Abschnitt der Tür (120) verbunden ist;
eine Kappe (150), die unter der Grundplatte (115) vorgesehen ist und einen darin ausgebildeten Aufnahmeraum aufweist, um einen Abschnitt der Verbindungsleitung (130) aufzunehmen, der sich aus dem Hohlraum (111) heraus erstreckt;
einen Kopplungsvorsprung (160), der sich in einer vertikalen Richtung an der Kappe (150) erstreckt und mit der Grundplatte (115) unter der Grundplatte (115) gekoppelt ist; und
ein Befestigungselement (190), das vom oberen Abschnitt der Grundplatte (115) durch die Grundplatte (115) eingesetzt ist, um die Grundplatte (115) und den Kopplungsvorsprung (160) zu koppeln.

2. Elektrische Kochvorrichtung nach Anspruch 1, die ferner ein in der Tür (120) vorgesehenes Steuerpult (140) aufweist,
wobei die Verbindungsleitung (130) in der Tür (120) mit dem Steuerpult (140) verbunden ist.

3. Elektrische Kochvorrichtung nach Anspruch 2,
wobei das Steuerpult (140) ein Bedienfeld, das durch eine Vorderseite freiliegt, und ein Substrat aufweist, das so in der Tür (120) eingebaut ist, dass es nicht durch die Vorderseite der Tür (120) freiliegt,
wobei die Verbindungsleitung (130) mit dem Substrat in der Tür (120) verbunden ist.

4. Elektrische Kochvorrichtung nach Anspruch 2 oder 3, wobei:
ein erstes Kopplungsloch (115c) in der Grundplatte (115) in einer vertikalen Richtung ausgebildet ist;
ein zweites Kopplungsloch (160c) nach oben im Kopplungsvorsprung (160) geöffnet ist; und
die Kappe (150) an einem Abschnitt installiert ist, an dem sich das erste Kopplungsloch (115c) und das zweite Kopplungsloch (160c) gegenseitig in einer vertikalen Richtung überlappen.

5. Elektrische Kochvorrichtung nach einem der Ansprüche 1 bis 4, wobei:
die Grundplatte (115) eine Passwand (115b) aufweist, die durch Biegen eines Umgebungsabschnitts des ersten Kopplungslochs (115c) in einer Richtung nach oben ausgebildet ist; und
der Kopplungsvorsprung (160) durch das erste Kopplungsloch (115c) mit der Passwand (115b) passgekoppelt ist.

6. Elektrische Kochvorrichtung nach Anspruch 5, wobei die Passwand (115b) nach oben verjüngt ist, so dass ein Durchmesser der ersten Kopplungslochs (115c) reduziert wird.

7. Elektrische Kochvorrichtung nach Anspruch 5 oder 6, die ferner einen Haken (170) aufweist, der an der Kappe (150) vorgesehen ist, durch die Grundplatte (115) über das Durchgangsloch (115a) eingesetzt ist und eine Innenumfangsfläche des Durchgangslochs (115a) berührt,
wobei eine Position der mit der Grundplatte (115) gekoppelten Kappe (150) in einer Richtung nach rechts und links über einen Kontakt zwischen dem Haken (170) und einer Innenumfangsfläche des Durchgangslochs (115a) an einer ersten Seite der Kappe (150) und einer Passkopplung zwischen dem Kopplungsvorsprung (160) und der Passwand (115b) an einer zweiten Seite der Kappe (150) geführt wird.

8. Elektrische Kochvorrichtung nach einem der Ansprüche 5 bis 7, die ferner eine Führungsrippe (180) aufweist, die an der Kappe (150) vorgesehen ist, durch die Grundplatte (115) über das Durchgangsloch (115a) eingesetzt ist und mit einer Innenumfangsfläche des Durchgangslochs (115a) in Kontakt steht,
wobei eine Position der mit der Grundplatte (115) gekoppelten Kappe (150) in einer Richtung nach vorn und hinten über eine Passkopplung zwischen dem Kopplungsvorsprung (160) und der Passwand (115b) und einem Kontakt der Führungsrippe (180) und einer Innenumfangsfläche des Durchgangslochs (115a) geführt wird.

9. Elektrische Kochvorrichtung nach einem der Ansprüche 4 bis 8, wobei das Befestigungselement (190) eine Schraube ist, die einer solchen Weise konfiguriert ist, dass ein Schraubenkörper (191) in das erste Kopplungsloch (115c) und das zweite Kopplungsloch (160a) vom oberen Abschnitt der Grundplatte (115) eingesetzt ist und an den Kopplungsvorsprung (160) geschraubt ist und ein Schraubenkopf (193) durch den oberen Abschnitt der Grundplatte (115) gehalten wird.

10. Elektrische Kochvorrichtung nach einem der Ansprüche 1 bis 9, wobei:
die Kappe (150) eine Bodenfläche (151), die von der Grundplatte (115) durch einen vorgegebenen Abstand beabstandet ist, und eine Seitenwand (153) aufweist, die sich von der Bodenfläche (151) in einer vertikalen Richtung erstreckt; und
ein oberer Endabschnitt von mindestens einem Abschnitt der Seitenwand (153) eine Unterseite der Grundplatte (115) berührt, um eine Aufwärtsbewegung der Kappe (150) einzuschränken.

11. Verfahren zum Montieren einer Kappe (150) der elektrischen Kochvorrichtung nach Anspruch 1, wobei das Verfahren aufweist:
drehbares Koppeln der Tür (120) vor dem Hohlraum (111) und Koppeln der Grundplatte (115) unter dem Hohlraum (111);
Anordnen einer Verbindungsleitung (130) durch das Durchgangsloch (115a) und elektrisches Verbinden eines inneren Abschnitts des Maschinenraums (110b) und eines inneren Abschnitts der Tür (120) durch die Verbindungsleitung (130);
Anordnen der Kappe (150) unter Grundplatte (115), um einen Abschnitt der Verbindungsleitung (130) aufzunehmen, der sich aus dem Hohlraum (111) heraus erstreckt; und
Anordnen eines Befestigungselements (190) durch die Grundplatte (115) von einem oberen Abschnitt der Grundplatte (115) und Koppeln der Grundplatte (115) und des Kopplungsvorsprungs (160).

12. Verfahren nach Anspruch 11, wobei das Anordnen der Kappe (150) unter der Grundplatte (115) das Einsetzen eines an der Kappe (150) vorgesehenen Hakens (170) in das Durchgangsloch (115a) aufweist, so dass der Haken (170) mit einer Innenumfangsfläche des Durchgangslochs (115a) in Eingriff tritt, und Passkoppeln des Kopplungsvorsprung (160) mit einer an der Grundplatte (115) vorgesehenen Passwand (115b).

## Revendications

1. Appareil de cuisson électrique présente une cavité (111) comprenant un compartiment de cuisson (110a) et un compartiment machine (110b) ;
une porte (120) raccordée de manière pivotante à la cavité (111) et prévue pour ouvrir et fermer le compartiment de cuisson (110a) ;
une plaque de base (115) prévue sous la cavité (111) et présentant en outre un orifice traversant (115a) ménagé dans la direction verticale ;
une ligne de connexion (130) sortant de la cavité (111) par l'orifice traversant (115a), ladite ligne de connexion (130) s'étendant également depuis le compartiment machine (110b) et étant relié à une partie intérieure de la porte (120) ;
un cache (150) prévu en dessous de la plaque de base (115), à l'intérieur duquel est formé un espace de réception pour loger une partie de la ligne de connexion (130) sortant de la cavité (111) ;
un bossage d'accouplement (160) s'étendant dans la direction verticale sur le cache (150) et raccordé à la plaque de base (115) en dessous de la plaque de base (115) ; et une fixation (190) insérée dans la plaque de base (115) par le haut de la plaque de base (115) pour raccorder la plaque de base (115) au bossage d'accouplement (160).

2. Appareil de cuisson électrique selon la revendication 1, comprenant en outre un panneau de commande (140) prévu dans la porte (120),
la ligne de connexion (130) étant reliée au panneau de commande (140) dans la porte (120).

3. Appareil de cuisson électrique selon la revendication 2,
où le panneau de commande (140) comprend un panneau de manipulation exposé par une surface avant et un substrat monté dans la porte (120) de manière à ne pas être exposé par la surface avant de la porte (120),
où la ligne de connexion (130) est reliée au substrat dans la porte (120).

4. Appareil de cuisson électrique selon la revendication 2 ou la revendication 3, où :
un premier orifice d'accouplement (115c) est formé dans la plaque de base (115) dans la direction verticale ;
un deuxième orifice d'accouplement (160c) est ouvert vers le haut dans le bossage d'accouplement (160) ; et
le cache (150) est mis en place dans une partie où le premier orifice d'accouplement (115c) et le deuxième orifice d'accouplement (160c) coïncident dans la direction verticale.

5. Appareil de cuisson électrique selon l'une des revendications 1 à 4, où :
la plaque de base (115) présente une paroi d'ajustement (115b) formée par pliage vers le haut d'une partie périphérique du premier orifice d'accouplement (115c) ; et
le bossage d'accouplement (160) est accouplé par ajustement avec la paroi d'ajustement (115b) par le premier orifice d'accouplement (115c).

6. Appareil de cuisson électrique selon la revendication 5, où la paroi d'ajustement (115b) s'amincit vers le haut de manière à réduire le diamètre du premier orifice d'accouplement (115c).

7. Appareil de cuisson électrique selon la revendication 5 ou la revendication 6, comprenant en outre un crochet (170) prévu sur le cache (150), inséré dans la plaque de base (115) par l'orifice traversant (115a), et contactant une surface circonférentielle intérieure de l'orifice traversant (115a),
où la position du cache (150) raccordé à la plaque de base (115) est guidée vers la gauche et vers la droite par contact entre le crochet (170) et une surface circonférentielle intérieure de l'orifice traversant (115a) sur un premier côté du cache (150) et accouplement par ajustement entre le bossage d'accouplement (160) et la paroi d'ajustement (115b) sur le deuxième côté du cache (150).

8. Appareil de cuisson électrique selon l'une des revendications 5 à 7, comprenant en outre une nervure de guidage (180) prévue sur le cache (150), insérée dans la plaque de base (115) par l'orifice traversant (115a), en contact avec une surface circonférentielle intérieure de l'orifice traversant (115a),
où la position du cache (150) raccordé à la plaque de base (115) est guidée vers l'avant et vers l'arrière par accouplement par ajustement entre le bossage d'accouplement (160) et la paroi d'ajustement (115b) et contact entre la nervure de guidage (180) et une surface circonférentielle intérieure de l'orifice traversant (115a).

9. Appareil de cuisson électrique selon l'une des revendications 4 à 8, où la fixation (190) est une vis prévue de telle manière qu'un corps de vis (191) est inséré dans le premier orifice d'accouplement (115c) et le deuxième orifice d'accouplement (160a) par le haut de la plaque de base (115) et est vissé vers le bossage d'accouplement (160), et qu'une tête de vis (193) est supportée par le sommet de la plaque de base (115).

10. Appareil de cuisson électrique selon l'une des revendications 1 à 9, où :
le cache (150) présente une surface de fond (151) espacée d'une distance définie de la plaque de base (115), et une paroi latérale (153) s'étendant depuis la surface de fond (151) dans la direction verticale ; et où
une partie d'extrémité supérieure d'au moins une partie de la paroi latérale (153) contacte une surface inférieure de la plaque de base (115) pour limiter un déplacement vers le haut du cache (150).

11. Procédé d'assemblage d'un cache (150) de l'appareil de cuisson électrique selon la revendication 1, ledit procédé comprenant :
le raccordement de manière pivotante de la porte (120) à l'avant de la cavité (111) et le raccordement de la plaque de base (115) sous la cavité (111) ;
la mise en place d'une ligne de connexion (130) passant par l'orifice traversant (115a), et la connexion électrique d'une partie intérieure du compartiment machine (110b) et d'une partie intérieure de la porte (120) par la ligne de connexion (130) ;
la mise en place du cache (150) sous la plaque de base (115) de manière à recevoir une partie de la ligne de connexion (130) sortant de la cavité (111) ; et
la mise en place d'une fixation (190) traversant la plaque de base (115) par le haut de la plaque de base (115) et le raccordement de la plaque de base (115) et du bossage d'accouplement (160).

12. Procédé selon la revendication 11,
où la mise en place du cache (150) sous la plaque de base (115) comprend l'insertion d'un crochet (170) prévu sur le cache (150) dans l'orifice traversant (115a) pour que le crochet (170) interfère avec une surface circonférentielle intérieure de l'orifice traversant (115a), et l'accouplement par ajustement du bossage d'accouplement (160) à une paroi d'ajustement (115b) prévue sur la plaque de base (115).
